Europäisches Patentamt

European Patent Office

Office européen des brevets

(19)

(11) Publication number: **0 229 486 B1**

# EUROPEAN PATENT SPECIFICATION

(12)

(45) Date of publication of patent specification: **30.09.92**　(51) Int. Cl.⁵: **H05K 13/08**, G01R 31/28

(21) Application number: **86309427.2**

(22) Date of filing: **03.12.86**

(54) **Automatic circuit adjusting systems.**

(30) Priority: **06.12.85 JP 274628/85**

(43) Date of publication of application:
**22.07.87 Bulletin 87/30**

(45) Publication of the grant of the patent:
**30.09.92 Bulletin 92/40**

(84) Designated Contracting States:
**DE ES FR GB**

(56) References cited:
**US-A- 4 384 334**

(73) Proprietor: **SONY CORPORATION**
**7-35 Kitashinagawa 6-chome Shinagawa-ku Tokyo 141(JP)**

(72) Inventor: **Isayama, Shigeo C/o Patents Division**
**Sony Corporation 6-7-35 Kitashinagawa Shinagawa-ku Tokyo 141(JP)**
Inventor: **Ogawa, Kazutoshi C/o Patents Division**
**Sony Corporation 6-7-35 Kitashinagawa Shinagawa-ku Tokyo 141(JP)**

(74) Representative: **Pilch, Adam John Michael et al**
**D. YOUNG & CO. 10 Staple Inn London WC1V 7RD(GB)**

EP 0 229 486 B1

## Description

This invention relates to automatic circuit adjusting systems which perform testing and adjustment of circuits, the circuits being provided on printed circuit boards.

US Patent No. US-A-4 384 334 discloses apparatus for driving pulse motors for automatically adjusting external circuits. The apparatus has a plurality of circuit adjusting tools, such as screwdrivers, for rotatingly adjusting circuit elements, such as potentiometers and the like, provided on printed circuit boards. Each of the circuit adjusting tools is fixedly located at a position corresponding to the orientation of an associated circuit element of the printed circuit board to be adjusted. In order to adjust the associated circuit element rotatably, each circuit adjusting tool is operated by a pulse motor which is operable independently of the other circuit adjusting tools. Operation of the pulse motors is controlled by means of a microprocessor. The microprocessor applies a test signal to the printed circuit board and compares the output data with predetermined standard data to derive control signals for the respective pulse motors to drive their associated circuit adjusting tools, so as to adjust the circuit so that it provides output data in response to the test data, which output data matches the predetermined standard data.

Such automatic circuit adjusting apparatus is effective for adjusting circuit elements on printed circuit boards. However, such apparatus is suitable for performing adjustment only for a specific structure of printed circuit board. The apparatus can adjust only printed circuit boards having an arrangement of circuit elements corresponding to the predetermined arrangement of the adjusting tools. When the arrangement of circuit elements on the printed circuit boards is modified, corresponding rearrangement is required for the circuit adjusting tools. Furthermore, since the apparatus employs a plurality of pulse motors so that each operates an associated circuit adjusting tool, the apparatus tends to be bulky and expensive.

According to the invention there is provided an automatic circuit adjusting system comprising:

an adjusting tool assembly provided with adjusting tools to perform adjustment on a circuit element provided on a printed circuit board;

driving means associated with the adjusting tools to drive the adjusting tools;

support means to support the printed circuit board in a predetermined orientation;

means to apply a preset test signal to the printed circuit board, to receive an output from the printed circuit board in response to the test signal and to compare the output from the printed circuit board with a predetermined reference signal so as to derive an error signal; and

control means to derive an adjusting magnitude for the circuit element to be adjusted based on the error signal and to produce a driver signal to drive the driving means at a magnitude corresponding to the value of the error signal;

characterised by a tool assembly frame to mount a single adjusting tool assembly of the adjusting tools, the tool assembly frame being movable within a predetermined two-dimensional coordinate system; and

means to shift the tool assembly frame according to a predetermined schedule successively to position the adjusting tool assembly in alignment with each of a plurality of the circuit elements to be adjusted in a specified order.

The single adjusting tool assembly may have a plurality of mutually different adjusting tools for performing adjustments on different circuit elements. The driving means preferably comprises a single driving motor designed for driving the plurality of adjusting tools and can be drivingly associated with each of the adjusting tools through a power train. The power train is designed so as to distribute constantly the driving torque of the driving motor to its respective adjusting tools.

The automatic circuit adjusting system may further comprise means selecting one of the adjusting tools according to the type of the circuit element to be adjusted, and coupling a selected one of the adjusting tools to the circuit element.

Alternatively, the adjusting tool may comprise a screwdriver for rotatably adjusting the circuit element to be adjusted, in which the circuit element includes a screw head to be rotated for adjustment, and the control means can adjust the driving torque of the driving means to drive the screwdriver with a first torque which is lower than that required for rotatably driving the screw head of the circuit element so as to establish engagement between a driver head of the screwdriver and the screw head. The control means can drive the screwdriver with the first torque for a given period of time which is determined in view of the maximum possible period required for establishing engagement between the driver head and the screw head.

Means may be provided to store angular position data relating to the screw head, so as to drive the screwdriver to the corresponding angular position to re-establish engagement between the driver head and the screw head after once performing adjustment of the circuit element.

Alternatively, the control means may be arranged to drive the driving means under the control of the means which continuously applies a test signal and monitors the output of the printed circuit board in order to stop the driving motor when the output of the printed circuit board changes.

A table memory storing position data of the circuit element may be provided to be adjusted with respect to the two-dimensional coordinate system to identify the orientation of the circuit element to be adjusted. The tool assembly frame may be provided on a carriage movable in a first direction parallel to one axis of the two-dimensional coordinate system, and on a second frame movable in a second direction parallel to the other axis of the two-dimensional coordinate system and perpendicular to said first direction.

The table memory may also store data identifying which one of the adjusting tools is to be used for performing adjustment of the circuit element to be adjusted. The means to shift the foot assembly frame may derive the shifting magnitude of the adjusting tool assembly for aligning the selected one of the adjusting tools to the circuit element to be adjusted.

The invention will now be described by way of example with reference to the accompanying drawings, throughout which like parts are referred to by like references, and in which:

Figure 1 is a front elevation of an automatic circuit adjusting system according to one embodiment of the invention;

Figure 2 is a side view of the automatic circuit adjusting system of Figure 1;

Figure 3 is a partial plan view of the automatic circuit adjusting system of Figures 1 and 2;

Figure 4 is an enlarged section of a position sensor for detecting the angular position of a pulse motor employed in the automatic circuit adjusting system of Figures 1 to 3;

Figure 5 is an enlarged section of a screwdriver assembly employed in the automatic circuit adjusting system of Figure 1;

Figure 6 is a block diagram of a control circuit for the automatic circuit adjusting system of Figure 1;

Figure 7 is a flowchart showing a control program for the automatic circuit adjusting system of Figures 1 to 6;

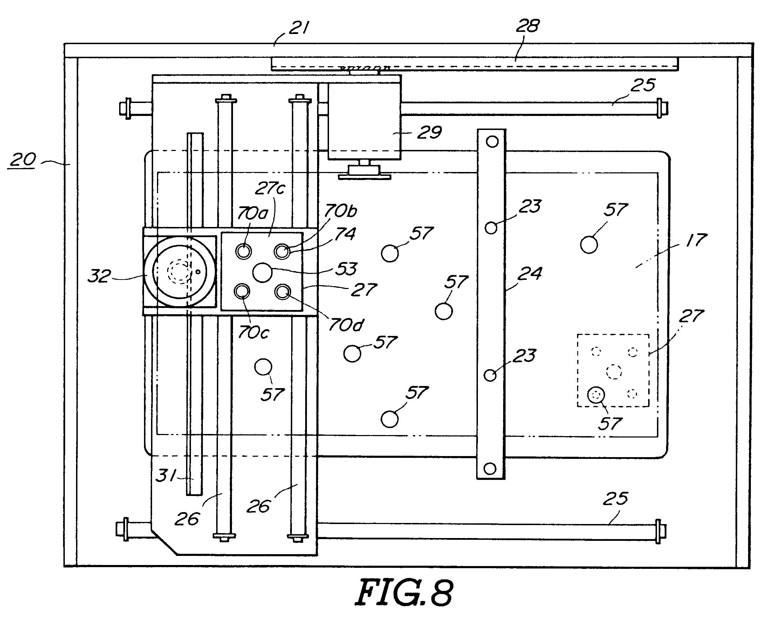

Figure 8 is a partial plan view of the automatic circuit adjusting system similar to that of Figure 3, but showing a shifted position of the screwdriver assembly by a broken line;

Figure 9 is a front elevation of the automatic circuit adjusting system similar to that of Figure 1, but showing a position where the screwdriver unit is axially shifted to an operating position;

Figure 10 is a side elevation of the automatic circuit adjusting system similar to that of Figure 2, but showing its position shifted to an operating position;

Figure 11 is a flowchart of a sub-routine of a control program to be executed at a step 1016 in the control program of Figure 7; and

Figure 12 is a flowchart of a sub-routine of a modification of the control program of Figure 7, which sub-routine is to be executed at a step 1014 of the control program.

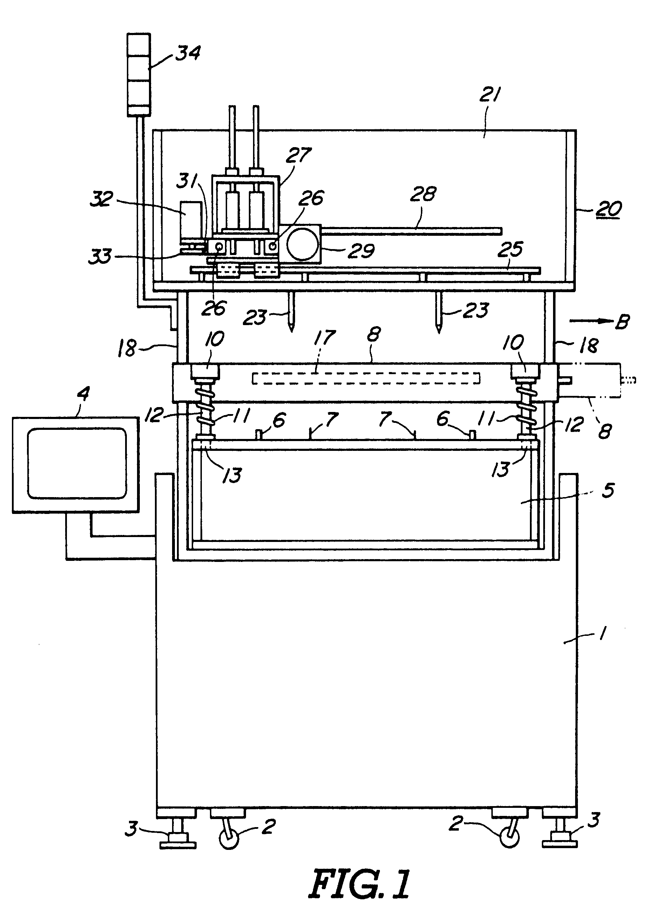

Referring now to the drawings, particularly to Figures 1 to 3, an automatic circuit adjusting system according to a preferred embodiment of the invention includes a generally hollow box-shaped base 1 housing a control circuit which will be discussed later in more detail. The control circuit may comprise a microcomputer, signal generator circuits, detectors and the like. The base 1 has a plurality of castors 2 so as to be movable. The base 1 also has a plurality of stopper legs 3. The castors 2 and the stopper legs 3 are located adjacent respective corners of the base 1. The stopper legs 3 are vertically movable between upper and lower positions. When the stopper legs 3 are in their upper positions, the lower ends of the legs are not in contact with the floor so as to allow the base 1 to move with the aid of the castors 2. On the other hand, when the stopper legs 3 are in their lower positions, the base 1 is lifted upwardly to place the castors 2 out of contact with the floor. Therefore, in the lower position, the stopper legs 3 prevent the base 1 from moving. A cathode ray tube (CRT) display 4 is provided at the side of the base 1. The CRT display 4 is connected to a microcomputer for displaying various data and information thereon.

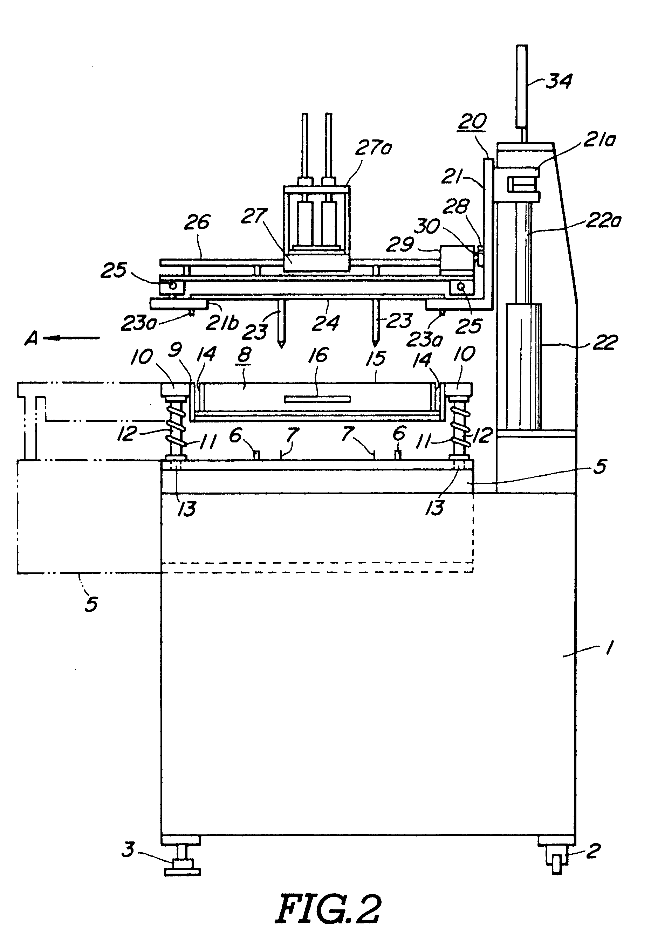

The base 1 is formed with a front and upper end open recess. A fixture 5 is removably received within the recess of the base 1. When the fixture 5 is inserted into the base 1, it enters horizontally from the front end opening of the recess in the opposite direction to an arrow A as shown in Figure 2. On the other hand, the fixture 5 is horizontally pulled out from the recess of the base 1 in the direction of the arrow A. The fixture 5 has positioning pins 6 and contact pins 7. The positioning pins 6 and the contact pins 7 protrude upwardly from the upper surface of the fixture 5.

A printed circuit board support 8 is provided over the fixture 5. The printed circuit board support 8 has a pallet frame 9. Projections 10 extend laterally from the pallet frame 9. Guide shafts 12 extend downwardly from the projections 10. The axes of the guide shafts 12 are positioned in alignment with through openings 13 formed through the fixture 5. Coil springs 11 are wound around the guide shafts 12. The upper ends of the coil springs 11 seat on lower surfaces of the projections 10. The lower ends of the coil springs 11 seat on the upper surface of the fixture 5. Therefore the printed circuit board support 8 is resiliently supported above and parallel to the fixture 5.

The printed circuit board support 8 further includes a pallet 15. The pallet 15 is thrustingly set in the pallet frame 9. The pallet 15 is designed so that a printed circuit board 17 may be fixedly mounted thereon. The pallet 15 is movable in a direction transverse to the direction indicated by the arrow A and can be removed by lateral thrusting movement relative to the fixture 5. A handle 16 is provided for the pallet 15 so that the pallet can be easily pulled out and set in the fixture 5. The direction of motion of the pallet 15 is indicated by an arrow B in Figure 1. Therefore the pallet 15 is movable between a set position where it is set in the fixture 5 for performing testing and adjustment of the circuit of the printed circuit board 17 and a released position where it protrudes laterally from the fixture 5 (as shown by a phantom line in Figure 1) and allows replacement of the printed circuit board 17 thereon.

A driver support 20 is provided above the fixture 5. The driver support 20 is supported by means of vertically extending guide frames 18 which extend upwardly from the base 1. The driver support 20 is vertically movable along the guide frames 18. The driver support 20 includes a movable frame 21. The movable frame 21 is of generally L-shaped configuration having a horizontally extending section and a vertically extending section. A projection 21a extends backwardly from the vertically extending section of the movable frame 21. The projection 21a is connected to the top of an actuation rod 22a of an air cylinder 22 which drives the movable frame 21 up and down along the guide frame 18.

The horizontal section of the movable frame 21 is of a generally rectangular configuration and is formed with a rectangular opening 21b in the midsection thereof. Through the opening 21b, push rods 23 extend downwardly from a pusher base 24 of a generally flat plate. The pusher base 24 is fixedly fitted on the upper surface of the horizontal section of the movable frame 21. The pusher base 24 may be formed of a synthetic resin plate, such as an acrylate resin plate. The pusher base 24 is formed with a plurality of through openings for receiving screwdrivers (which will be discussed later) therethrough to access circuit elements to be adjusted. Therefore the through openings are arranged at the positions corresponding to and in alignment with the adjustable circuit elements which are to be adjusted.

In an alternative arrangement, the pusher base 24 may comprise one or more narrow plates arranged so as not to interfere with access by the screwdrivers to the adjustable circuit elements.

The push rods 23 are arranged to detect whether the printed circuit board 17 is accurately set in the fixture 5. When the movable frame 21 is driven downwardly by means of the air cylinder 22, the lower ends of the push rods 23 contact the printed circuit board 17 so that the printed circuit board can be fixed on the pallet 15. On the other hand, the push rods 23 may also serve as stoppers for stopping downward movement of the movable frame 21.

A plurality of push rods 23a also extend downwardly from the lower surface of the horizontal section of the movable frame 21. The push rods 23a oppose the upper edge of the pallet support frame 9 to depress the latter downwardly according to downward movement of the movable frame 21.

A pair of guide bars 25 extend laterally along the movable frame 21. The direction along which the guide bars 25 extend will hereafter be referred to as the "x-axis direction". The guide bars 25 are arranged apart from each other and are located adjacent the front and rear ends of the movable frame 21. A carriage 27a of a screwdriver assembly 27 is movably mounted on the guide bars 25 for movement along the x-axis direction. A pair of guide bars 26 are fixedly mounted on the upper surface of the carriage 27a. The guide bars 26 extend in a direction perpendicular to the x-axis direction which will hereafter be referred to as the "y-axis direction". A tool assembly frame in the form of a screwdriver unit frame 27b is movably mounted on the guide bus 26 for movement along the y-axis direction.

An x and y coordinate system is formed with respect to the printed circuit board 17 to be tested and adjusted. The x-axis of the coordinate system extends laterally with respect to the movable frame 21 and the y-axis of the coordinate system extends in the front-to-rear direction of the movable frame 21.

A rack plate 28 with a plurality of rack teeth is provided along the guide bars 25. The rack plate 28 is fixed onto the vertical wall of the movable frame 21. A pinion gear 30 engages with the rack teeth of the rack plate 28. The pinion gear 30 is fixedly mounted on an output shaft 29a of a pulse motor 29 which is mounted on the carriage 27a. Therefore the pinion gear 30 is rotatably driven by means of the pulse motor 29 to drive the carriage 27a along the guide bus 25. Since the screwdriver unit frame 27b is fixedly mounted on the carriage 27a as described above, the screwdriver unit frame is shifted in the x-axis direction with the carriage 27a by means of the pulse motor 29. Another pulse motor 32 is mounted on the screwdriver unit frame 27b. The pulse motor 32 is designed to rotatably drive a pinion gear 33 through its output shaft 32a. The pinion gear 33 engages with a rack plate 31 having a plurality of rack teeth. The rack plate 31 is fixedly mounted on the carriage 27a and extends in the direction of the guide bars 26. Therefore, by driving the pulse motor 32, the screwdriver unit frame 27b is driven in the y-axis direction with respect to the carriage 27a.

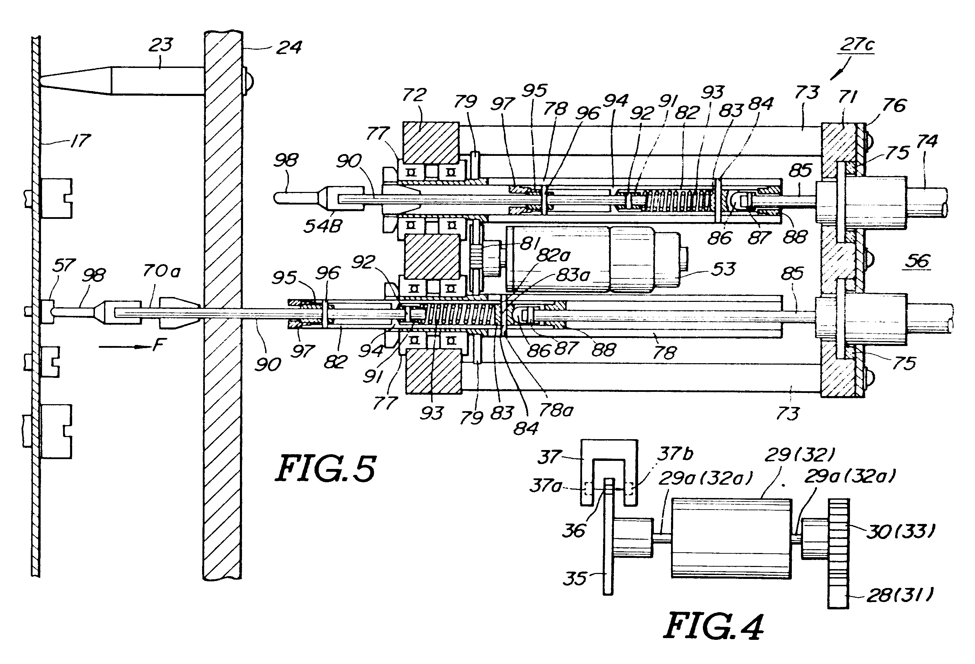

In the illustrated embodiment, the output shafts 29a and 32a of the pulse motors 29 and 32 extend from both sides of the motor bodies. The pinion gears 30 and 33 are each fixed on one end of each of the output shafts, as described above. On the other hand, rotary discs 35 are fixed to the other ends of the output shafts 29a and 32a of the pulse motors 29 and 32. Each of the rotary discs 35 is formed with an aperture 36. The aperture 36 is positioned away from the centre of the rotary disc 35 and adjacent the peripheral edge of the rotary disc. The peripheral edge portion of the rotary disc 35 is inserted within a recess formed in a photosensor 37. As shown in Figure 4, the photosensor 37 comprises a light emitting element 37a and a light sensing element 37b. The light emitting element 37a emits a light beam towards the light sensing element 37b. The aperture 36 in the rotary disc 35 is so arranged as to be aligned with the light emitting element 37a at the initial angular position of the associated pulse motor 29 or 32. The light sensing element 37b thus receives the light beam emitted from the light emitting element 37a only when the respective pulse motor is in its initial angular position.

When the carriage 27a of the screwdriver assembly 27 is placed at an initial position, the pulse motor 29 is arranged to be in its initial angular position. Similarly, when the screwdriver unit frame 27b is in an initial position, the pulse motor 32 is arranged to be in its initial angular position. The pulse motors 29 and 32 are respectively designed to be driven through a given angle by a signal driving pulse applied thereto. Therefore, by applying a known number of driving pulses, a known angle of angular displacement can be caused in each of the pulse motors 29 and 32. Therefore, by controlling the number of driving pulses to be applied to the pulse motors 29 and 32, the angular positions of the pulse motors can be controlled and thereby the positions of the carriage 27a and the screwdriver unit frame 27b can be controlled. The number of driving pulses to be applied to the pulse motors 29 and 32 is controlled by a microprocessor 41 which forms a main part of a control circuit. Details of the control circuit will be discussed later.

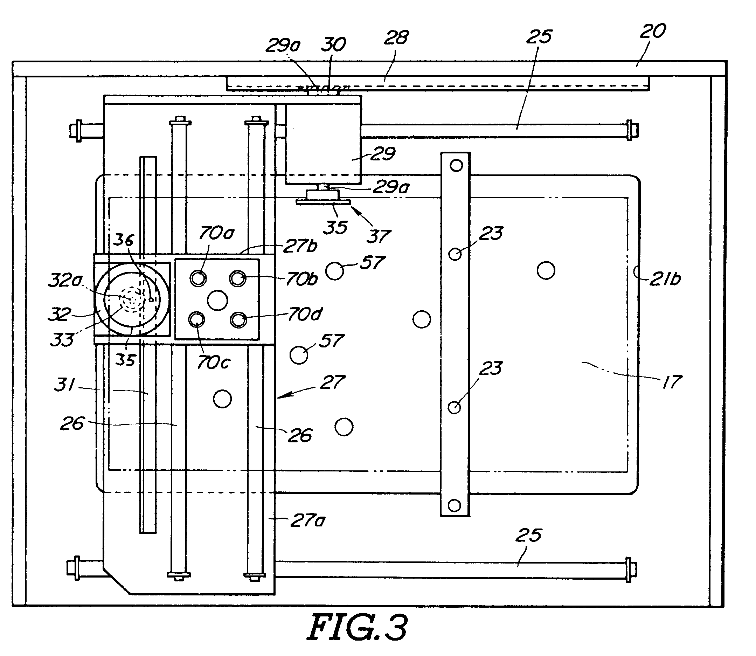

As shown in Figure 5, a screwdriver unit 27c is mounted on the screwdriver unit frame 27b for movement therewith. The screwdriver unit 27c comprises upper and lower frame members 71 and 72. Each of the upper and lower frame members 71 and 72 is formed in a square or rectangular configuration in plan view. Cylindrical bar members 73 are inserted between the upper and lower frame members 71 and 72 for supporting the latter members in a spaced apart relationship parallel to each other. As shown in Figure 5, the bar members 73 are fixed adjacent the corners of the upper and lower frame members 71 and 72. The frame members 71 and 72 support four screwdriver devices 70a, 70b, 70c and 70d, as shown in Figure 3. Each of the screwdriver devices 70a, 70b, 70c and 70d has a different type of bit from the others. The bits of the respective screwdriver devices 70a, 70b, 70c and 70d are selected depending upon the types of the screw heads of the circuit elements to be adjusted.

Each screwdriver device 70a, 70b, 70c and 70d comprises coaxially arranged outer and inner cylindrical sleeves 78 and 82. A driver shaft 90 extends through the inner sleeve 82. A driver head 98 is fitted to the lower end of the driver shaft 90 for rotation therewith. The driver shaft 90 has a radially extended flange section 92. This flange section 92 mates with an annular projection 94 extending from the inner periphery of the inner sleeve 82, to limit the downward axial movement with respect to the inner sleeve. A coil spring 93 is disposed within the internal space of the inner sleeve 82 above the driver shaft 90. The lower end of the coil spring 93 is seated onto another annular projection 94a extending from the inner periphery of the inner sleeve 82 and located above the annular projection 94. The upper end of the coil spring 93 is seated onto a fitting block 83 inserted within the internal space of the inner sleeve 82. The fitting block 83 is formed so as to extend laterally through an opening 83a. The fitting block 83 is arranged within the internal space of the inner sleeve 82 so as to align the opening 83a with openings 82a and 78a formed through the peripheries of the inner and outer sleeves 82 and 78, respectively. A keying pin 84 extends through the aligned openings 78a, 82a and 83a. The openings 78a and 82a of the outer and inner sleeves 78 and 82 are in the form of axially extending grooves. These grooves form the openings 82a and 78a and allow axial movement of the inner sleeve 82 with respect to the outer sleeve 78 and of the driver shaft 90 with respect to the inner sleeve 82.

An air cylinder 74 is fitted onto the upper frame member 71. The air cylinder 74 has a radially extending flange 74a which is inserted within a mounting recess 71a formed in the upper frame member 71. The flange 74a is fixed to the upper frame member 71 by means of a fitting ring 75 and a fitting plate 76. The air cylinder 74 has an actuation rod 85 with a round-headed top 86. The round-headed top 86 is fixed to the lower end of the actuation rod 85 of the air cylinder 74 by means of a keying pin 87. A fitting block 88 is fitted to the top of the inner sleeve 82 and allows the actuation rod 85 to pass therethrough. The round-headed top 86 is inserted within the internal space of the outer sleeve 78 for thrusting movement therealong. The round-headed top 86 mates with the fitting block 83. The actuation rod 85 is driven by means of the air cylinder 74 to drive the inner sleeve 82 and the driver shaft 90 downwardly and upwardly. A fitting block 95 and a driver support member 97 are fitted at the lower end of the inner sleeve 82. A keying pin 96 extends through the periphery of the inner sleeve 82 and the fitting block 95.

With this arrangement, the inner and outer sleeves 82 and 78 and the driver shaft 90 are rotatable together. The outer cylindrical sleeve 78 is rotatably supported on the lower frame member 72 through bearings 77. A drive motor 53 is provided in the screwdriver unit 27c for driving the screwdriver devices 70a, 70b, 70c and 70d. The drive motor 53 has an output shaft 53a on which a drive gear 81 is fixedly mounted. The drive gear 81 drivingly engages with four driven gears 79 which are fixed to the outer periphery of the respectively corresponding outer sleeves 78 so as each to rotate with the associated outer sleeve. Therefore the screwdriver devices 70a, 70b, 70c and 70d are driven by the driving torque of the drive motor 53 transmitted through the drive gear 81 and the driven gears 79.

The drive motor 53 and the air cylinders 74 are also controlled by the control circuit. In practice, the control circuit selects one of the screwdriver devices 70a, 70b. 70c and 70d according to the type of screw head of the circuit element to be adjusted. The control circuit activates a selected one of the air cylinders 74 of the screwdriver devices 70a, 70b, 70c and 70d so as to shift the driver head 98 downwards together with the inner sleeve 82 and the driver shaft 90. The control circuit also controls driving of the drive motor 53.

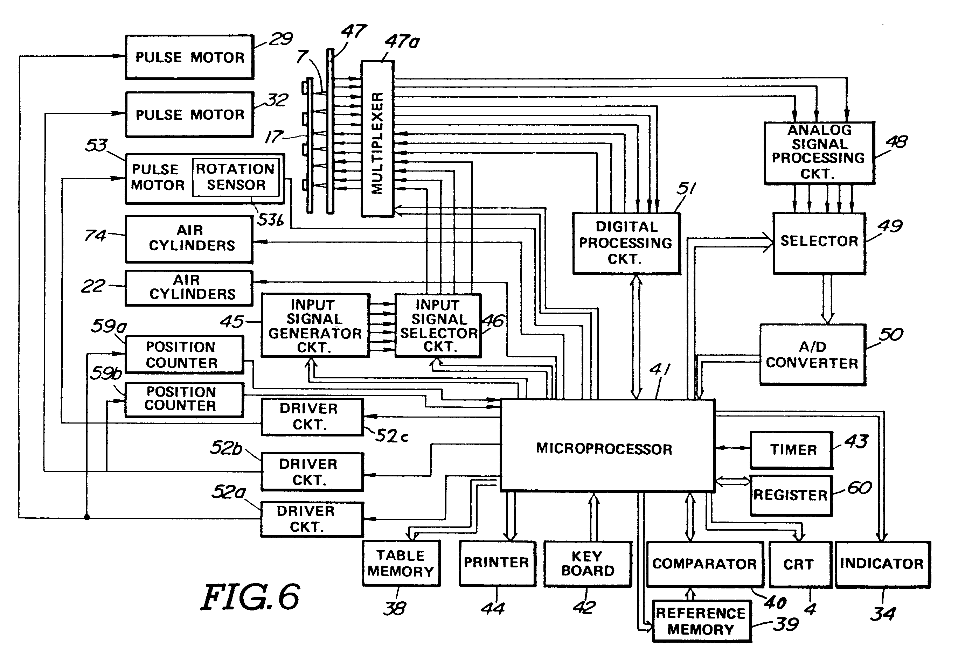

As shown in Figure 6, the control circuit comprises the microprocessor 41 which is connected to a keyboard 42, the CRT display 4 and a printer 44. Control commands are input to the microprocessor 41 through the keyboard 42. Various information, such as test data, output data and the like is displayed on the CRT display 4 and is printed by means of the printer 44.

The microprocessor 41 is also connected to an input signal selector circuit 46. The input signal selector circuit 46 is in turn connected to an input signal generator circuit 45 which produces various input signals necessary for testing the printed circuit boards. For example, when testing and adjusting printed circuit boards for video tape recording and/or reproducing apparatus, the input signals will be a white signal, a colour-bar signal, a drop-out detecting signal and the like. Alternatively, when testing and adjusting printed circuit boards for audio tape recording and/or reproducing apparatus, the input signals will be a sine-wave signal and the like. The input signal generator circuit 45 may comprise a plurality of signal generators designed for generating the aforementioned input signals. The input signal selector circuit 46 selects one or more input signals from the input signal generator circuit 45 to apply to the printed circuit board 17 to be tested and adjusted through a contact plate 47 and the contact pins 7. A buffer/multiplexer circuit 47a is provided for selectively applying test signals according to preset schedules. The buffer/multiplexer circuit 47a is, in turn, connected to the microprocessor 41 so as to be controlled by a multiplexing control signal therefrom. The microprocessor 41 is also connected to a digital signal processing circuit 51. The digital signal processing circuit 51 is controlled by the microprocessor 41 according to the input command entered through the keyboard 42 and generates digital test data. The digital test data is also fed to the contact plate 47 through the buffer/multiplexer circuit 47a and to the printed circuit board 17 to be tested and adjusted through the contact pins 7.

Analog outputs which are produced in response to application of the input signals through the input signal selector circuit 46 from the printed circuit board 17 are received by an analog signal processing circuit 48 through the contact pins 7 and the contact plate 47. Digital outputs which are produced in response to application of the digital test data from the printed circuit board 17 are received by the digital signal processing circuit 51.

The analog signal processing circuit 48 is connected to a signal selector circuit 49. The signal selector circuit 49 is controlled by the microprocessor 41 to select one of the output signals from the printed circuit board 17 and feed it to an analog-to-digital (A/D) converter 50. The A/D converter 50 converts the analog signal input from the signal selector circuit 49 into a digital signal which is supplied to the microprocessor 41. The digital signal processing circuit 51 feeds the received output data directly to the microprocessor 41. The microprocessor 41 applies the received input data from the digital processing circuit 51 or the A/D converter 50 to a comparator 40. The comparator 40 is, in turn, connected to a reference memory 39. The reference memory 39 stores various reference data respectively corresponding to input signals and digital test data to be applied to the printed circuit board 17 to be tested. The microprocessor 41 accesses one of the memory blocks in the reference memory 39 to bad out the reference data corresponding to the testing input applied to the printed circuit board 17. The comparator 40 compares the data from the microprocessor 41 with the read reference data. A comparator signal indicative of the difference between the compared data is produced by the comparator 40. The comparator signal is fed to the microprocessor 41.

The microprocessor 41 also produces screwdriver selection signals and screwdriver unit shift control signals as control signals. A table memory 38 is provided to store position data of respective circuit elements of the printed circuit board to be adjusted. The table memory 38 also stores data concerning the screw head type. The microprocessor 41 reads out position data and screw head data from the table memory 38 on the basis of the comparator signal from the comparator 40 to derive the screwdriver selection signal depending upon the type of the screw head of the circuit element to be adjusted. The microprocessor 41 also derives the screwdriver shift control signal based on the position data of the circuit element to be adjusted. The screwdriver selection signal is fed to one of the actuators (not shown) of the air cylinders 74 for actuating the air cylinder corresponding to the selected driver head 98. The screwdriver unit shift control signals are applied to driver circuits 52a and 52b respectively operative to generate driver pulses to drive the pulse motors 29 and 32 for shifting the carriage 27a and the screwdriver unit frame 27b of the screwdriver assembly 27. By driving the pulse motor 29, the carriage 27a is shifted in the x-axis direction. Also, by driving the pulse motor 32, the screwdriver unit frame 27b is shifted in the y-axis direction. During the x-axis and y-axis direction movements of the carriage 27a and the screwdriver unit frame 27b, the positions of the screwdriver devices are monitored by counting the driver pulses which are output from the driver circuits 52a and 52b. An x-axis position counter 59a and a y-axis position counter 59b are provided to input count data to the microprocessor 41. The x-axis position counter 59a is connected to the driver circuit 52a for counting the driver pulses therefrom. The y-axis position counter 59b is connected to the driver circuit 52b for counting the driver pulses therefrom.

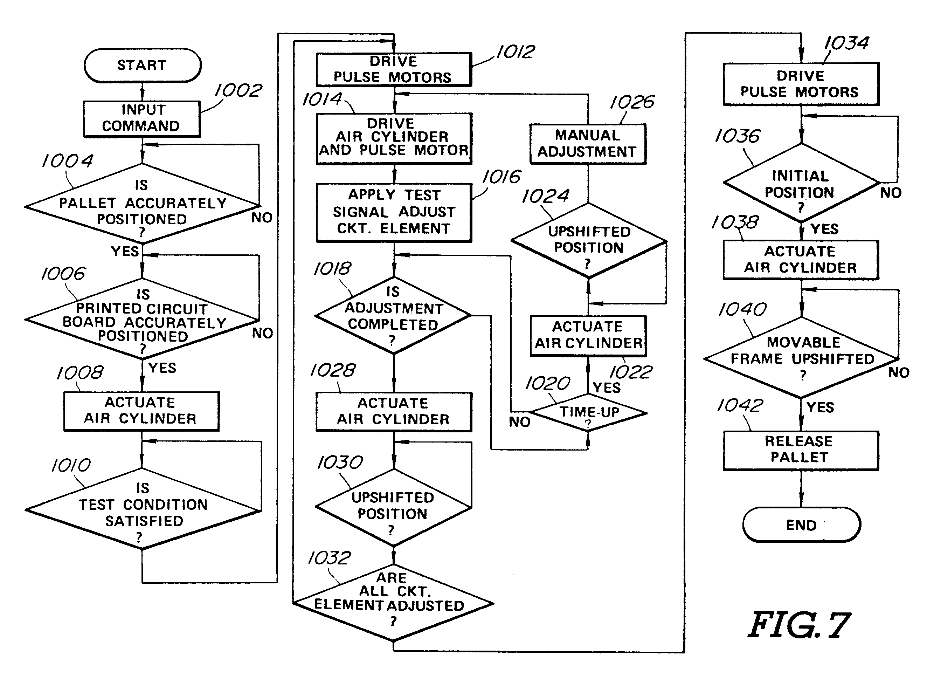

Operation of the aforementioned automatic circuit adjusting system according to the preferred embodiment of the invention will be described herebelow with reference to a flowchart of a printed circuit board testing and adjusting program as shown in Figure 7. The program of Figure 7 is triggered in response to insertion of the pallet 15 into the pallet support 9. After entry into execution of the testing and adjusting program, the microprocessor 41 is placed in a stand-by state for performing testing and adjusting operations in response to a command to be entered by means of the keyboard 42. Accordingly, at a step 1002, the command is checked cyclically or sequentially until the keyboard 42 is operated to issue the command. In response to the command through the keyboard, the pallet position is checked at a step 1004 to determine whether the pallet 15 is set in the predetermined position or not. Then, at a step 1006, a check is performed to determine whether the printed circuit board 17 is set on the pallet 15 in the correct manner or not. In practice, checking of the pallet position and the printed circuit board direction or orientation is performed by means of optical sensors (not shown) fixed to the fixture 5 and the pusher base 24.

When the pallet 15 is not set at the predetermined position or the printed circuit board 17 is not set in the correct direction as checked at the steps 1004 and 1006, the execution of the program loops for respectively given periods of time. When either the pallet 15 or the printed circuit board 17 cannot be set within the given period of time, the microprocessor 41 generates an alarm signal. The alarm signal may be fed to an indicator 34 (shown in Figure 6) and/or the CRT display 4. Therefore the indicator 34 may be switched on to indicate an abnormal condition. At the same time, the CRT display 4 may display faulty data.

On the other hand, if it is confirmed that the pallet 15 is set at the predetermined position and the printed circuit board 17 is set in the correct direction as checked at the steps 1004 and 1006, the air cylinder 22 is activated to move the driver unit support 20 downwardly, at a step 1008. By downward movement of the driver unit support 20, the push rods 23 come into contact with the printed circuit board 17 on the pallet 15. At the same time, the push rods 23a provided on the movable frame 21 come into contact with the peripheral wall of the pallet 15. Then the air cylinder 22 is again activated to lift the driver unit support 20 upwardly until the driver unit support reaches an upwardly shifted predetermined position. Upward and downward movement of the driver unit support 20 is repeated several times. In a practical embodiment, the aforementioned operation for shifting the driver unit support upwardly and downwardly is performed three times. During this upward and downward movement of the driver unit support 20, the contact pins 7 repeatedly contact and release respectively associated contact points on the printed circuit board 17. This effectively removes the flux layer formed on a substrate of the printed circuit board 17 to assure test signal transmission through the contact pins 7.

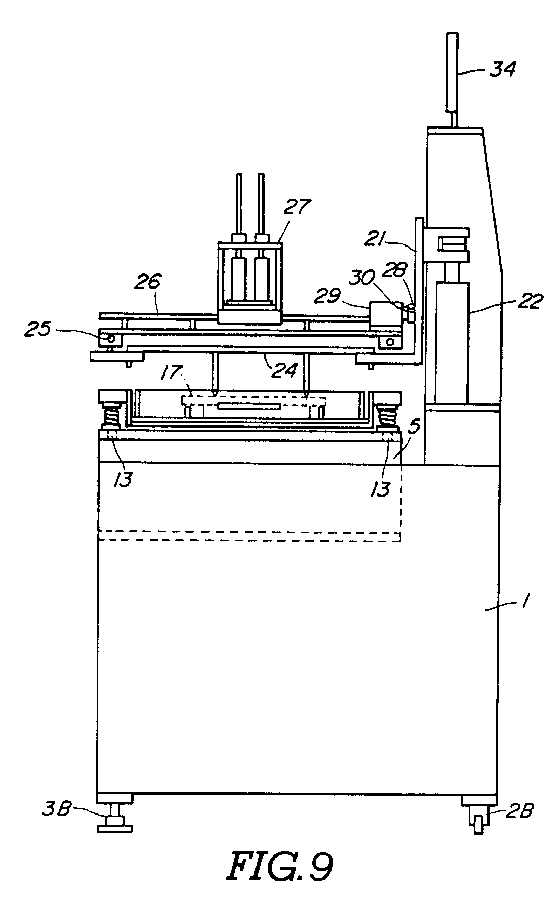

The upward and downward operation of the driver unit support 20 ends after a given number of cycles of operation, for example three cycles, and at the driver unit support position shifted down so that the push rods 23 contact the printed circuit board 17, as shown by a broken line in Figure 9. At the same time, the contact pins 7 contact with the printed circuit board for supplying the test signal(s) and/or test data therethrough. This condition is confirmed at a step 1010. After the condition of Figure 9 is confirmed at the step 1010, the system starts testing and adjusting operations of the printed circuit board 17 set in the predetermined position. At a step 1012, the microprocessor 41 accesses the table memory 38 for locating the pre-programmed position of a first circuit element to be adjusted. The microprocessor 41 reads out the the x- and y-coordinate data of the first circuit adjusting element and also the screw head type indicative data from the table memory 38. Based on the read data, the microprocessor 41 selects one of the driver devices 70a, 70b, 70c and 70d to be used for performing adjustment of the first circuit element, based on the screw head type indicative data. The microprocessor 41 also derives a magnitude of shifting in the x-axis direction of the carriage 27a and a magnitude of shifting in the y-axis direction of the screwdriver unit frame 27b based on the x- and y-coordinates of the first adjusting circuit element and the selected screwdriver device position. The microprocessor 41 then produces a screwdriver unit shift control signal to be supplied to the driver circuits 52a and 52b. The screwdriver unit shift control signal to be supplied to the driver circuit 52a is indicative of the shifting magnitude of the carriage 27a of the screwdriver assembly 27. On the other hand, the screwdriver unit shift control signal to be supplied to the driver circuit 52b is indicative of the shifting magnitude of the screwdriver unit frame 27b in the y-axis direction. In response to the screwdriver unit shift control signals, the driver circuits 52a and 52b become active to feed driver pulses to the pulse motors 29 and 32.

The pulse motor 29 is driven by the driver pulses from the driver circuit 52a, and drives the pinion gear 30. As described, the pinion gear 30 is engaged with the rack 28 extending in the x-axis direction. Therefore, the carriage 27a is shifted in the x-axis direction for a controlled magnitude according to the number of driver pulses produced by the driver circuit 52a. During this x-axis shifting of the carriage 27a, the driver pulses to be supplied to the pulse motor 29 are also input to the x-axis position counter 59a. The x-axis position counter 59a feeds back the x-axis position signal indicative of the x-axis position of the carriage 27a to the microprocessor 41.

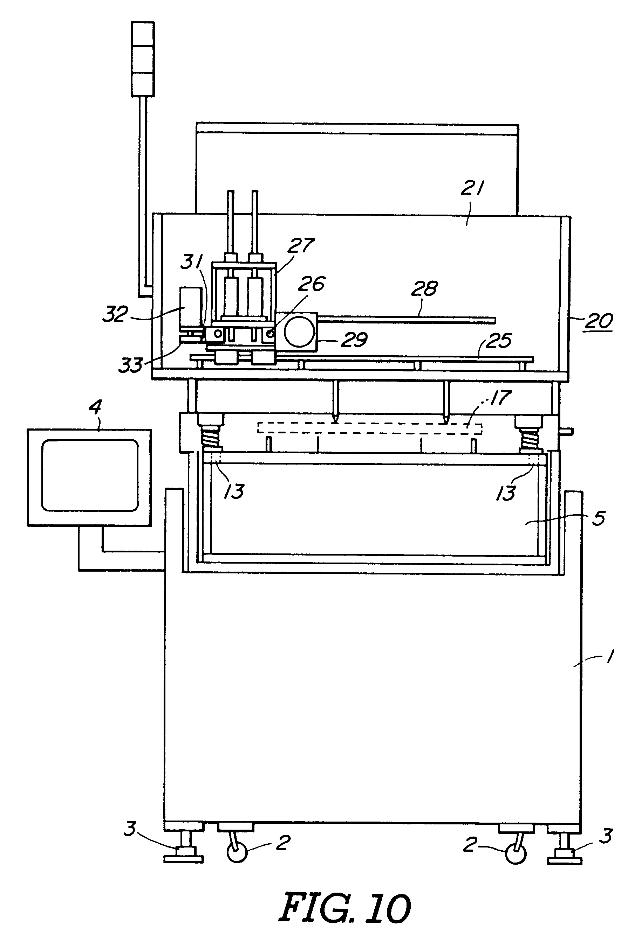

On the other hand, the pulse motor 32 is driven by the driver pulses from the driver circuit 52b, and drives the pinion gear 33. As described, the pinion gear 33 is engaged with the rack gear 31 extending in the y-axis direction. Therefore, the screwdriver unit frame 27b is shifted in the y-axis direction for a controlled magnitude according to the number of driver pulses produced by the driver circuit 52b. During this y-axis shifting of the screwdriver unit frame 27b, the driver pulses to be supplied to the pulse motor 32 are also input to the y-axis position counter 59b. Therefore, the screwdriver assembly 27 is placed to align the driver head 98 of the selected one of the driver devices 70a, 70b, 70c and 70d with the screw head of the first adjusting circuit element, as shown in Figures 9 and 10. The x-axis position counter 59b feeds back the y-axis position signal indicative of the y-axis position of the carriage 27a to the microprocessor 41.

The microprocessor 41 receives the x- and y-axis positions of the carriage 27a and the screwdriver unit frame 27b and thereby detects the instantaneous position in the x- and y-coordinates of the selected screwdriver device 70a, 70b, 70c or 70d. Therefore, the microprocessor 41 detects that the selected one of the screwdriver devices 70a, 70b, 70c and 70d is in alignment with the first adjusting circuit element. Then, the microprocessor 41 provides an instruction for the driver circuits 52a and 52b to stop supplying the driver pulses.

Then, at a step 1014, the microprocessor 41 outputs the driver selection signal and the screwdriver drive signal. The driver selection signal is supplied to one of the actuators associated with the selected one of the screwdriver devices. On the other hand, the screwdriver drive signal is supplied to a further driver circuit 52c. The screwdriver drive signal is representative of the required driving torque of the pulse motor 53 for adjusting the driving torque to be applied to the screwdriver devices 70a, 70b, 70c and 70d. In practice, the driving torque of the pulse motor 53 may be adjusted between a predetermined small torque which is insufficient for driving the screw head of the adjusting screw of the circuit element to be adjusted, and a greater torque sufficient for driving the screw head for causing angular displacement of the adjusting screw of the circuit element. The driver circuit 52c thus supplies a first drive signal to drive the pulse motor 53 with a smaller torque and a second drive signal to drive the pulse motor with a greater torque.

In order to establish engagement between the driver head 98 of the selected one of the screwdriver devices and the first adjusting circuit element, the microprocessor 41 at first supplies the screwdriver drive signal representative of the smaller torque. Therefore, the driver circuit 52c outputs the first drive signal for driving the pulse motor 53 with the smaller torque. In response to the first drive signal from the driver circuit 52c, the pulse motor 53 is driven with the smaller torque to drive all of the screwdriver devices 70a, 70b, 70c and 70d by transmitting the smaller driving torque through the drive gear 81 and the driven gears 79 which are fixed to the outer sleeves 78 of the screwdriver devices. Since the outer sleeve 78 is keyed with the inner sleeve 82 for rotation together, but so as to allow axial movement of the inner sleeve with respect thereto, and the inner sleeve 82 is keyed with the driver shaft 90 for rotation together and so as to allow the latter to axially shift with respect thereto, the inner sleeve 82 and the driver shaft 90 are driven to rotate with the smaller driving torque.

In synchronism with driving of the pulse motor 53, the driver selection signal is applied to the actuator of the air cylinder 74 of the selected one of the screwdriver devices 70a, 70b, 70c and 70d. Therefore the air cylinder 74 associated with the selected screwdriver device becomes active to increase the air pressure in the cylinder so as to depress the inner sleeve 82 with the driver shaft 90. The inner sleeve 82 shifts downwardly with the driver shaft 90 until the lower end edge thereof comes into contact with the upper edge of the fitting block 95. When the lower edge contacts the upper edge of the fitting block 95, the inner sleeve 82 is prevented from shifting further downwardly. Thus only the driver shaft 90 shifts further downwardly to allow the driver head 98 to reach the screw head of the first adjusting circuit element. Since the screwdriver device is driven with the smaller torque, which is insufficient to drive the adjusting screw of the first adjusting circuit element, rotation of the driver shaft 90 is braked and stops when the driver head engages with the screw head of the adjusting screw. By stopping rotation of the selected one of the screwdriver devices, the power train constituted by the drive gear 81 and the driven gears 79 is braked so as not to rotate. Therefore, the reacting torque exerted on the pulse motor 53 increases thus stopping driving of the motor. This is detected by a rotation sensor 53b incorporated in the pulse motor 53. The rotation sensor 53b then feeds a sensor signal indicative of stopping of the motor. In response to the sensor signal, the microprocessor 41 terminates the driver selection signal and the screwdriver drive control signal to stop the pulse motor and to stop downward driving of the air cylinder 74.

At a step 1016, the microprocessor 41 performs a testing operation for testing the printed circuit board 17 according to the pre-set schedule. Namely, the microprocessor 41 sends activating commands to the input signal generator circuit 45 and to the digital signal processing circuit 51. The input signal generator circuit 45 is thus activated to produce various analog test signals and feeds the test signals to the input signal selector circuit 46. Also, the digital signal processing circuit 51 produces test data. The test signal selected by the input signal selector circuit 46 and the test data from the digital signal processing circuit 51 are selectively applied to the contact pins 7 (via the buffer/multiplexer circuit 47a and the contact plate 47) for performing testing of the printed circuit board 17.

The output from the printed circuit board 17, in response to application of the test signal and/or test data, is received through the contact pins 7. The outputs through the contact pins 7 are selected by the buffer/multiplexer circuit 47a and selectively fed to the digital signal processing circuit 51 and the analog signal processing circuit 48. The digital signal processing circuit 51 produces test result indicative data to be input to the microprocessor 41. The analog signal processing circuit 48 feeds a test result indicative analog signal produced in response to the input from the buffer/multiplexer circuit 47a. The test result indicative analog signal is selected by the signal selector circuit 49 and then A/D converted by the A/D converter 50 into test result indicative digital data. The microprocessor 41 applies the received test result indicative data to the comparator 40. At the same time, the microprocessor 41 accesses the associated memory block of the reference memory 39 for reading out reference data to be compared with the test result indicative data. The comparator 40 outputs a signal indicative of the result of the comparing operation, as described above. The microprocessor 41 also derives a driving magnitude for the pulse motor 43 to determine an angular displacement of the adjusting screw of the first adjusting circuit element. Based on the derived displacement angle, the microprocessor 41 produces the screwdriver drive signal indicative of a required greater torque of the pulse motor 53 and indicative of the given cycles of motor revolution required for causing the required angular displacement in the adjusting screw of the first adjusting circuit element. In response to the screwdriver drive control signal, the driver circuit 52c feeds the driving signal to the pulse motor 53 to provide the required cycles of motor revolution with the greater torque so as to rotate the screw head of the adjusting screw of the first adjusting circuit element. During this adjustment operation, the rotation sensor 53b detects the angular shift of the screw head of the adjusting screw of the first adjusting circuit element, and feeds the resulting sensor signal to the microprocessor 41. The microprocessor 41 temporarily writes in the angular position data, together with data identifying the adjusting circuit element, in a register 60. Testing and adjusting with respect to the first adjusting circuit element is cyclically and repeatedly performed until the test result indicative data is in a predetermined relationship with the associated reference data, as checked by the comparator 40. Therefore, at a step 1018, the comparator output is checked as to whether the specific relationship between the test result indicative data and the reference data has been obtained or not. After checking completion of adjustment at the step 1018, a time value generated by a timer 43 is checked to see whether it is greater than a given time value, at a step 1020, if it has been found that adjustment has not been completed. The timer 43 is designed to measure an elapsed time from starting of the testing and adjusting operation after the selected one of the screwdriver devices 70a, 70b, 70c and 70d is placed in alignment and the driver head 98 of the selected screwdriver device enters into engagement with the screw head of the adjusting screw of the first adjusting circuit element. When the timer value is less than the given value, the process returns to the step 1018 to perform the testing and adjusting operation again. On the other hand, when the timer value has become greater than or equal to the given value, then the process goes to a routine allowing manual adjustment to be undertaken. In this case, the microprocessor 41 produces a fail signal to be fed to the indicator 34 for indicating the need for manual adjustment. At the same time, the microprocessor 41 feeds a fail data indicative signal to the CRT display 4 for displaying information as to the faulty circuit element which requires manual adjustment. Furthermore, the microprocessor 41 outputs a screwdriver device position control signal for shifting the screwdriver device upwardly, at a step 1022, so as to release the driver head 98 for the screw head of the adjusting screw of the first adjusting circuit element, by activating the appropriate air cylinder. A check is performed to determine whether the screwdriver device has reached the predetermined upwardly shifted position at a step 1024. This check is performed by providing a detector which is suitable for detecting the screwdriver device position. After confirming the upwardly-shifted position of the screwdriver device, manual adjustment can be performed at a step 1026. In order to resume automatic testing and adjustment, the command is again entered through the keyboard 42.

In response to re-entry of the command, the microprocessor 41 re-starts the automatic testing and adjusting operation from the step 1014. Then the microprocessor 41 again produces the screwdriver device position control signal to activate the air cylinder 74 of the corresponding screwdriver device 70a, 70b, 70c or 70d. Therefore the screwdriver device shifts the driver head 98 downwardly to again establish engagement with the screw head of the first adjusting circuit element. Then, the microprocessor 41 repeats the testing process at the steps 1016 and 1018.

After confirming that that test result indicative data is in a predetermined relationship with the reference data, the microprocessor 41 produces the screwdriver position control signal for shifting the screwdriver device upwardly to release the driver head 98 from the screw head of the adjusting screw of the first adjusting circuit element, at a step 1028. The screwdriver device position at the predetermined upwardly shifted position is confirmed at a step 1030. After the step 1030, a check is made at a step 1032 to determine whether all of the circuit elements have been adjusted or not. This check at the step 1032 is performed by checking if the circuit element which has just been adjusted in the aforementioned cycle of the testing and adjusting operation is the last circuit element to be adjusted according to the preset adjustment schedule.

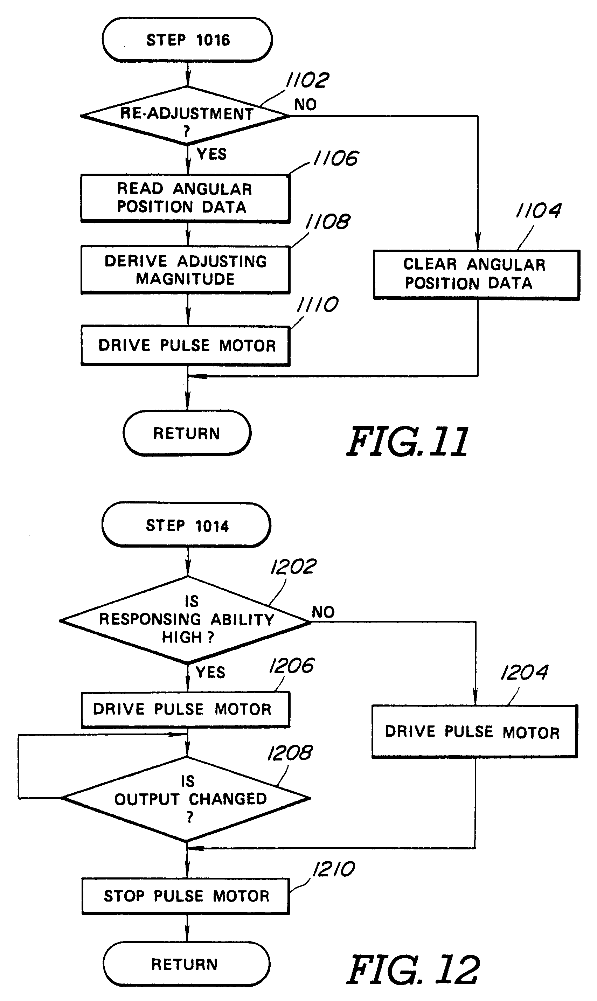

During the aforementioned cycles of testing and adjusting operations, it may become necessary to perform re-adjustment of the already-adjusted circuit elements. In such a case, the microprocessor 41 determines the already-adjusted circuit element to be re-adjusted based on the test result indicative data and derives the screwdriver unit shift control signals to return the screwdriver assembly 27 to the circuit element to be re-adjusted. Then the testing and adjusting operation in the steps 1012 to 1018 is performed again. In order to allow readjustment, the adjustment routine of the step 1014 may be performed in the procedure as shown in Figure 11. In the adjustment routine of Figure 11, at first a check is made whether the adjustment of the angular position of the screw head of the adjusting screw of the associated circuit element is for initial adjustment or re-adjustment, at a step 1102. When the adjustment to be performed is the initial adjustment, then the content of a memory block in the register 60 corresponding to the circuit element to be adjusted, is cleared for storing angular position data in the subsequent adjusting operation, at a step 1104. On the other hand, when the adjustment to be performed is re-adjustment of an already-adjusted circuit element, the corresponding memory block in the register 60 is accessed by the microprocessor 41 for reading out the angular position of the adjusting screw of the circuit element to be adjusted, at a step 1106. The microprocessor 41 derives the angular position of the adjusting screw of the circuit element based on the test result data. Based on the angular position data as read at the step 1106, and the derived angular position towards which the adjusting screw is to be adjusted, the microprocessor 41 derives the required angular shift for the associated circuit element and thus produces the screwdriver drive signal and the driver selection signal, at a step 1108. According to the screwdriver drive signal and the driver selection signal, the aforementioned adjusting operation is performed at a step 1110.

At this time, since testing and adjustment for only the first adjusting circuit element is effectively complete, testing and adjustment have to be performed with respect to the subsequently-scheduled circuit elements. In order to perform testing and adjustment of the subsequently-scheduled circuit elements, the process returns to the step 1012. In the step 1012, the microprocessor 41 reads out the x- and y-coordinate data and the screw head type data of the text circuit element to be tested and adjusted. Then the steps 1012 to 1032 are repeated until the testing and adjusting for the scheduled last circuit element has been completed.

When completion of testing and adjustment has been detected at the step 1032, the process goes to a step 1034 for returning the carriage 27a and the screwdriver unit frame 27b to their respective initial positions. Therefore, the microprocessor 41 derives the shifting magnitude of the carriage 27a and the screwdriver unit frame 27b based on the x-and y-coordinates of the last circuit element to have been adjusted. Based on the derived shifting magnitude, the microprocessor 41 derives the screwdriver shift control signals for driving the pulse motors 29 and 32.

At a step 1036, the initial positions of the carriage 27a and the screwdriver unit frame 27b are confirmed. After the step 1036, the air cylinder 22 is deactivated to shift the movable frame 21 upwardly, at a step 1038. By shifting the movable frame 21 upwardly, the push rods 23 release their contact with the printed circuit board 17. At the same time, the push rods 23a release contact with the pallet support frame 9 to release the contact pins 7 from contacting the printed circuit board 17. In this condition, the pallet 15 can be removed from the pallet support frame 9.

In the aforementioned automatic circuit adjusting system, setting of the screwdriver in engagement with the screw head of the adjusting screw of the circuit element to be adjusted is performed by applying a smaller driving torque to the driver head. However, it would be possible to set the driver head in its engaged position and detect the setting of the driver head in engagement with the screw head of the adjusting screw by detecting variation of the output, by applying a driving torque sufficient for rotating the adjusting screw and detecting the variation of the output of the printed circuit board caused by angular displacement of the adjusting screw. This screwdriver setting process is particularly advantageous when the circuit in the printed circuit board has a high response ability with respect to the angular displacement of the circuit element to be adjusted. Also it would be possible to use selectively both of the aforementioned procedures for setting the screwdriver in engagement with the screw head of the circuit element to be adjusted. In such cases, a routine as shown in Figure 12 may be used as a sub-routine of the program of Figure 7. This sub-routine of Figure 12 may be triggered at the step 1014. In addition, in order to enable selection of the aforementioned processes, the data stored in the table memory 38 is arranged to include data indicative of the response ability of the circuit of the printed circuit board relative to the angular displacement of the associated adjusting screw.

During execution of the sub-routine of Figure 12, at first the table memory 38 is accessed to check whether the response ability of the circuit is high enough to set the driver head in engagement with the screw head of the adjusting screw of the circuit element to be adjusted, or not, based on the table data, at a step 1202. When the response ability of the circuit with respect to the circuit element to be adjusted is low, the microprocessor 41 produces the screwdriver drive signal initiating high-speed, smaller torque, at a step 1204. On the other hand, when the response ability is high enough, the microprocessor 41 produces the screwdriver drive signal indicative of greater torque, at a step 1206. Then the microprocessor 41 monitors the output of the printed circuit board 17 fed through the contact pins 7 to detect variation of the output data, at a step 1208. When variation of the output data is detected, the microprocessor 41 stops the screwdriver drive signal to stop the pulse motor 53 at a step 1210.

The procedure for setting the driver head in engagement with the screw head of the adjusting screw may be simplified by simply driving the screwdriver devices at the lower torque for a predetermined period of time. Although this procedure may take a relatively longer period of time to perform testing and adjustment, and cannot check the angular position of the adjusting screw, it may be preferred when lower cost is desired.

As will be appreciated, the automatic circuit adjusting system is applicable for testing and adjusting various printed circuit boards without requiring substantial re-arrangement of the system. In order to modify the system for different printed circuit boards, it is only necessary to replace the table memory data, the reference memory data and the driver heads corresponding to the printed circuit boards to be tested and adjusted. Furthermore, since the screwdriver unit has a relatively simple construction, it may be composed in a sufficiently compact manner to allow the overall system also to be compact.

It should be appreciated that, although the preferred embodiment of the automatic circuit adjusting system employs a screwdriver assembly for performing the adjusting operation of the printed circuit boards, the system may instead be applicable to various processes by utilising various other tools. For instance, if marking heads are attached to the carriage in a manner similar to that of the screwdriver unit, marking operations can be automatically effected on the printed circuit board.

**Claims**

1. An automatic circuit adjusting system comprising:

   an adjusting tool assembly (27) provided with adjusting tools (70a to 70b) to perform adjustment on a circuit element provided on a printed circuit board (17);

   driving means (53) associated with the adjusting tools (70a to 70d) to drive the adjusting tools (70a to 70d);

   support means (8) to support the printed circuit board (17) in a predetermined orientation;

   means (40,41) to apply a preset test signal to the printed circuit board (17), to receive an output from the printed circuit board (17) in response to the test signal, and to compare the output from the printed circuit board (17) with a predetermined reference signal so as to derive an error signal; and

   control means (52c) to derive an adjusting magnitude for the circuit element to be adjusted based on the error signal and to produce a driver signal to drive the driving means (53) at a magnitude corresponding to the value of the error signal;

   characterised by a tool assembly frame (27b) to mount a single adjusting tool assembly (27) of the adjusting tools (70a to 70d), the tool assembly frame being movable within a predetermined two-dimensional coordinate system; and

   means (29,32) to shift the tool assembly frame (27b) according to a predetermined schedule successively to position the adjusting tool assembly (27) in alignment with each of a plurality of the circuit elements to be adjusted in a specified order.

2. A system according to claim 1, wherein the tools (70a to 70d) of the single adjusting tool assembly (27) comprise a plurality of mutually different adjusting tools (70a to 70d) to perform adjustments on different circuit elements.

3. A system according to claim 2, wherein the driving means comprises a single driving motor (53) arranged to drive the plurality of adjusting tools (70a to 70d).

4. A system according to claim 3, wherein the driving motor (53) is drivingly associated with each of the adjusting tools (70a to 70d) through a power train (79,81).

5. A system according to claim 4, wherein the power train (79,81) is designed so as to distribute constantly the driving torque of the driving motor (53) to the adjusting tools (70a to 70d).

6. A system according to any one of claims 2 to 5, comprising means (74) to select one of the adjusting tools (70a to 70d) according to the type of the circuit element to be adjusted and to couple the selected one of the adjusting tools (70a to 70d) to the circuit element.

7. A system according to any one of the preceding claims, wherein each of the adjusting tools comprises a screwdriver (70a) rotatably to adjust the circuit element to be adjusted, in which the circuit element includes a screw head to be rotated for adjustment, and the control means (52c) is operable to adjust the driving torque of the driving means (53) to drive the screwdriver (70a) with a first torque which is lower than that required rotatably to drive the screw head of the circuit element, so as to establish engagement between a driver head (98) of the screwdriver (70a) and the screw head.

8. A system according to claim 7, wherein the control means (52c) is operable to drive the screwdriver (70a) with said first torque for a given period of time which is determined with respect to the maximum possible period required for establishing engagement between the driver head (98) and the screw head.

9. A system according to claim 8, comprising means (38) to store angular position data of the screw head so that the screwdriver (70a) can be driven to the corresponding angular position to re-establish engagement between the driver head (98) and the screw head after once performing adjustment of the circuit element.

10. A system according to any one of claims 1 to 6, wherein each of the adjusting tools comprises a screwdriver (70a) rotatably to adjust the circuit element to be adjusted, in which the circuit element includes a screw head to be rotated for adjustment, and the control means (52c) is operable to drive the driving means (53) under the control of the means (40,41) to apply a preset test signal which is operable continuously to apply a test signal and to monitor the output from the printed circuit board (17) in order to stop the driving means (53) when the output from the printed circuit board (17) changes.

11. A system according to any one of the preceding claims, wherein the means to shift the tool assembly frame (27b) includes a table memory (38) storing position data of the circuit element to be adjusted with respect to the two-dimensional coordinate system, so as to identify the orientation of the circuit element to be adjusted.

12. A system according to claim 11, wherein the tool assembly (27b) is provided on a carriage movable in a first direction parallel to one axis of the two-dimensional coordinate system, and on a second frame (27a) movable in a second direction parallel to the other axis of the two-dimensional coordinate system and perpendicular to said first direction.

13. A system according to claim 11 or claim 12, wherein the table memory (38) stores data identifying one of the adjusting tools (70a to 70d) which is to be used for performing adjustment of the circuit element to be adjusted.

14. A system according to claim 13, wherein the means (29,32) to shift the tool assembly frame derives a shifting magnitude of the adjusting tool assembly (27) for aligning the selected one of the adjusting tools (70a to 70d) with the circuit element to be adjusted.

**Patentansprüche**

1. Automatische Vorrichtung zum Einstellen von Schaltungen,
mit einer Einstellwerkzeuganordnung (27), die mit Einstellwerkzeugen (70a bis 70d) zum Durchführen der Einstellung an einem auf einer gedruckten Schaltung (17) angebrachten Schaltungselement bestückt ist,
mit einer mit den Einstellwerkzeugen (70a bis 70d) verbundenen Antriebseinrichtung (53) zum Antreiben der Einstellwerkzeuge (70a bis 70d),
mit einer Halterung (8) zum Halten der gedruckten Schaltung (17) in einer festgelegten Orientierung,
mit einer Einrichtung (40,41), die der gedruckten Schaltung (17) ein voreingestelltes Testsignal zuführt, von der gedruckten Schaltung (17) ein Ausgangssignal als Antwort auf das Testsignal empfängt und das Ausgangssignal der gedruckten Schaltung (17) zur Ermittlung eines Fehlersignals mit einem vorbestimmten Referenzsignal vergleicht,

und mit einer Steuereinrichtung (52c), die für das einzustellende Schaltungselement auf der Basis des Fehlersignals eine Einstellgröße ermittelt und ein Antriebssignal der dem Wert des Fehlersignals entsprechenden Größe zum Antreiben der Antriebseinrichtung (53) erzeugt, gekennzeichnet durch
eine innerhalb eines vorgegebenen zweidimensionalen Koordinatensystems bewegbare Werkzeughalterung (27b) zur Montage einer einzelnen Einstellwerkzeuganordnung (27) mit den Einstellwerkzeugen (70a bis 70d)
und eine Einrichtung (29, 32) zum Verschieben der Werkzeughalterung (27b) nach einem vorgegebenen Fahrplan, um die Einstellwerkzeuganordnung (27) nacheinander in Ausrichtung mit jedem einzelnen einer Mehrzahl von in einer festgelegten Reihenfolge einzustellenden Schaltungselementen zu positionieren.

2. Vorrichtung nach Anspruch 1, wobei die Werkzeuge (70a bis 70d) der einzelnen Einstellwerkzeuganordnung (27) eine Mehrzahl sich voneinander unterscheidender Einstellwerkzeuge (70a bis 70d) zur Durchführung von Einstellungen bei verschiedenen Schaltungselementen umfassen.

3. Vorrichtung nach Anspruch 2, wobei die Antriebseinrichtung einen einzelnen, für das Antreiben der Mehrzahl von Einstellwerkzeugen (70a bis 70d) eingerichteten Antriebsmotor (53) umfaßt.

4. Vorrichtung nach Anspruch 3, wobei der Antriebsmotor (53) mit jedem der Einstellwerkzeuge (70a bis 70d) antriebsmäßig über ein Kraftübertragungsteil (79, 81) verbunden ist.

5. Vorrichtung nach Anspruch 4, wobei das Kraftübertragungsteil (79, 81) so ausgebildet ist, daß es das Drehmoment des Antriebsmotors (53) ständig auf die Einstellwerkzeuge (70a bis 70d) überträgt.

6. Vorrichtung nach einem der Ansprüche 2 bis 5, umfassend eine Einrichtung (74) zur Auswahl eines der Einstellwerkzeuge (70a bis 70d), je nach Art des einzustellenden Schaltungselements, und zur Ankoppelung des ausgewählten Einstellwerkzeugs (aus 70a bis 70d) an das Schaltungselement.

7. Vorrichtung nach einem der vorhergehenden Ansprüche, dadurch gekennzeichnet, daß jedes der Einstellwerkzeuge einen Schraubenzieher (70a) zur drehenden Einstellung des einzustellenden Schaltungselements umfaßt, wobei das Schaltungselement einen für die Einstellung zu drehenden Schraubenkopf enthält,

und daß durch die Steuereinrichtung (52c) das Drehmoment des Antriebsmotors (53) so eingestellt werden kann, daß es den Schraubenzieher (70a) mit einem Drehmoment, welches kleiner ist als zum Drehen des Schraubenkopfes des Schaltungsele mentes erforderlich, antreibt und so die Verbindung zwischen einem Einsatz (98) des Schraubenziehers (70a) und dem Schraubenkopf herstellt.

8. Vorrichtung nach Anspruch 7, wobei die Steuereinrichtung (52c) den Schraubenzieher (70a) für eine bestimmte Zeitspanne, deren Länge mit Bezug auf die maximal für das Herstellen der Verbindung zwischen dem Schraubenziehereinsatz (98) und dem Schraubenkopf erforderliche Zeitdauer festgelegt wird, mit dem ersten Drehmoment antreibt.

9. Vorrichtung nach Anspruch 8, umfassend eine Einrichtung (38) zum Speichern von Winkelpositionsdaten des Schraubenkopfes, so daß der Schraubenzieher (70a) nach einmaligem Durchführen der Einstellung des Schaltungselementes zum Wiederherstellen der Verbindung zwischen Schraubenziehereinsatz (98) und Schraubenkopf in die entsprechende Winkelposition gebracht werden kann.

10. Vorrichtung nach einem der Ansprüche 1 bis 6, dadurch gekennzeichnet, daß jedes der Einstellwerkzeuge einen Schraubenzieher (70a) zur drehenden Einstellung des einzustellenden Schaltungselements umfaßt, wobei das Schaltungselement einen für die Einstellung zu drehenden Schraubenkopf enthält,

und daß die Steuereinrichtung (52c) geeignet ist, die Antriebseinrichtung (53) unter Steuerung durch die Einrichtung (40, 41) zum Anlegen eines voreingestellten Testsignals anzutreiben, welche ständig ein Testsignal anlegt und das Ausgangssignal der gedruckten Schaltung (17) überwacht, um die Antriebseinrichtung (53) abzuschalten, sobald sich das Ausgangssignal der gedruckten Schaltung (17) ändert.

11. Vorrichtung nach einem der vorhergehenden Ansprüche, wobei die Einrichtung zum Verschieben der Werkzeughalterung (27b) einen Tabellenspeicher (38) zur Speicherung der Positionswerte des einzustellenden Schaltungselements bezüglich des zweidimensionalen Koordinatensystems enthält, um die Orientierung des einzustellenden Schaltungselementes zu erkennen.

12. Vorrichtung nach Anspruch 11, wobei die Werkzeughalterung (27b) auf einem in einer ersten Richtung, parallel zu einer Achse des zweidimensionalen Koordinaten systems, bewegbaren Schlitten und auf einer in einer zweiten Richtung, parallel zur anderen Achse des zweidimensionalen Koordinatensystems und senkrecht zur ersten Richtung, bewegbaren zweiten Halterung (27a) angebracht ist.

13. Vorrichtung nach Anspruch 11 oder 12, wobei der Tabellenspeicher (38) Werte zur Identifizierung von einem der Einstellwerkzeuge (70a bis 70d) speichert, welches zum Ausführen der Einstellung am einzustellenden Schaltungselement verwendet werden soll.

14. Vorrichtung nach Anspruch 13, wobei die Einrichtung (29, 32) zum Verschieben der Werkzeughalterung die Größe der Verschiebung der Einstellwerkzeugeinrichtung (27) ermittelt, um das ausgewählte der Einstellwerkzeuge (70a bis 70d) mit dem einzustellenden Schaltungselement auszurichten.

**Revendications**

1. Système automatique d'ajustage de circuit comprenant :

un assemblage d'outils d'ajustage (27) comprenant des outils d'ajustage (70a à 70d) pour effectuer un ajustage sur un élément de circuit monté sur une plaquette de circuit imprimé (17) ;

un moyen de pilotage (53) associé aux outils d'ajustage (70a à 70d) pour piloter les outils d'ajustage (70a à 70d) ;

un moyen de support (8) pour supporter la plaquette de circuit imprimé (17) selon une orientation prédéterminée ;

un moyen (40, 41) pour appliquer un signal de test pré-établi à la plaquette de circuit imprimé (17) afin de recevoir une sortie en provenance de la plaquette de circuit imprimé (17) en réponse au signal de test et afin de comparer la sortie en provenance de la plaquette de circuit imprimé (17) à un signal de référence prédéterminé de manière à en dériver ou déduire un signal d'erreur ; et

un moyen de commande (52c) pour dériver ou déduire une amplitude d'ajustage pour les éléments de circuit qui doivent être ajustés sur la base d'un signal d'erreur et pour produire un signal de pilotage pour piloter le moyen de pilotage (53) selon une amplitude correspondant à la valeur du signal d'erreur ;

caractérisé par un châssis d'assemblage d'outils (27b) pour monter un unique assemblage d'outils d'ajustage (27) des outils d'ajustage (70a à 70d), le châssis d'assemblage d'outils étant mobile dans un système de coordonnées à deux dimensions prédéterminé ; et

un moyen (29, 32) pour décaler le châssis d'assemblage d'outils (27b) selon une règle ou programme prédéterminé afin de positionner successivement l'assemblage d'outils d'ajustage (27) en alignement avec chacun d'une pluralité d'éléments de circuit qui doivent être ajustés selon un ordre spécifié.

2. Système selon la revendication 1, dans lequel les outils (70a à 70d) de l'unique assemblage d'outils d'ajustage (27) comprennent une pluralité d'outils d'ajustage mutuellement différents (70a à 70d) pour effectuer des ajustages sur différents éléments de circuit.

3. Système selon la revendication 2, dans lequel le moyen de pilotage comprend un unique moteur de pilotage (53) agencé pour piloter la pluralité d'outils d'ajustage (70a à 70d).

4. Système selon la revendication 3, dans lequel le moteur de pilotage (53) est associé du point de vue de l'entraînement à chacun des outils d'ajustage (70a à 70d) par l'intermédiaire d'une transmission (79, 81).

5. Système selon la revendication 4, dans lequel la transmission (79, 81) est conçue de manière à distribuer de façon constante le couple d'entraînement du moteur de pilotage (53) sur les outils d'ajustage (70a à 70d).

6. Système selon l'une quelconque des revendications 2 à 5, comprenant un moyen (74) pour sélectionner l'un des outils d'ajustage (70a à 70d) en relation avec le type de l'élément de circuit qui doit être ajusté et pour coupler l'outil sélectionné pris parmi les outils d'ajustage (70a à 70d) à l'élément de circuit.

7. Système selon l'une quelconque des revendications précédentes, dans lequel chacun des outils d'ajustage comprend un tournevis (70a) qui peut tourner pour ajuster l'élément de circuit qui doit être ajusté, dans lequel l'élément de circuit inclut une tête de vis qui doit être tournée pour l'ajustage et le moyen de commande (52c) peut être actionné pour ajuster le couple d'entraînement du moyen de pilotage (53) afin de piloter le tournevis (70a) avec un premier couple qui est inférieur à celui nécessaire pour entraîner en rotation la tête de vis de l'élément de circuit de manière à établir un enclenchement entre une tête de tournevis (98) du tournevis (70a) et la tête de vis.

8. Système selon la revendication 7, dans lequel le moyen de commande (52c) peut fonctionner pour piloter le tournevis (70a) avec ledit premier couple pendant une période temporelle donnée qui est déterminée par rapport à la période maximale possible requise pour établir un enclenchement entre la tête de tournevis (98) et la tête de vis.

9. Système selon la revendication 8, comprenant un moyen (38) pour stocker des données de position angulaire de la tête de vis de telle sorte que le tournevis (70a) puisse être piloté jusqu'à la position angulaire correspondante afin de ré-établir une coopération entre la tête de tournevis (98) et la tête de vis après que l'ajustage de l'élément de circuit a été effectué une fois.

10. Système selon l'une quelconque des revendications 1 à 6, dans lequel chacun des outils d'ajustage comprend un tournevis (70a) qui peut tourner pour ajuster l'élément de circuit qui doit être ajusté, dans lequel l'élément de circuit inclut une tête de vis qui peut être tournée pour l'ajustage et le moyen de commande (52c) peut être actionné pour piloter le moyen de pilotage (53) sous la commande du moyen (40, 41) afin d'appliquer un signal de test pré-établi qui peut agir en continu pour appliquer un signal de test et pour surveiller la sortie en provenance de la plaquette de circuit imprimé (17) afin d'arrêter le moyen de pilotage (53) lorsque la sortie en provenance de la plaquette de circuit imprimé (17) varie.

11. Système selon l'une quelconque des revendications précédentes, dans lequel le moyen pour décaler le châssis d'assemblage d'outils (27b) inclut une mémoire de tables (38) qui stocke des données de position de l'élément de circuit qui doit être ajusté par rapport au système de coordonnées à deux dimensions de manière à identifier l'orientation de l'élément de circuit qui doit être ajusté.

12. Système selon la revendication 11, dans lequel le châssis d'assemblage d'outils (27b) est prévu sur un chariot mobile suivant une première direction parallèle à un axe du système de coordonnées à deux dimensions et sur un second châssis (27a) mobile suivant une seconde direction parallèle à l'autre axe du système de coordonnées à deux dimensions et perpendiculaire à ladite première direction.

13. Système selon la revendication 11 ou 12, dans lequel la mémoire de tables (38) stocke des données qui identifient l'un des outils d'ajustage (70a à 70d) qui doit être utilisé pour effectuer l'ajustage de l'élément de circuit qui doit être ajusté.

14. Système selon la revendication 13, dans lequel le moyen (29, 32) pour décaler le châssis d'assemblage d'outils déduit une amplitude de décalage de l'assemblage d'outils d'ajustage (27) pour aligner l'outil d'ajustage sélectionné pris parmi les outils d'ajustage (70a à 70d) avec l'élément de circuit qui doit être ajusté.

**FIG.1**

FIG.2

**FIG.3**

EP 0 229 486 B1

FIG.5

FIG.4

FIG.6

EP 0 229 486 B1

START

INPUT
COMMAND — 1002

1004 — IS
PALLET ACCURATELY
POSITIONED
? — NO

YES

1006 — IS
PRINTED CIRCUIT
BOARD ACCURATELY
POSITIONED
? — NO

YES

1008 — ACTUATE
AIR CYLINDER

1010 — IS
TEST CONDITION
SATISFIED
?

DRIVE
PULSE MOTORS — 1012

1014 — DRIVE
AIR CYLINDER
AND PULSE MOTOR

APPLY TEST
SIGNAL ADJUST
CKT. ELEMENT — 1016

1018 — IS
ADJUSTMENT
COMPLETED
?

1028 — ACTUATE
AIR CYLINDER

1030 — UPSHIFTED
POSITION
?

1032 — ARE
ALL CKT.
ELEMENT ADJUSTED
?

1026 — MANUAL
ADJUSTMENT

1024 — UPSHIFTED
POSITION
?

ACTUATE
AIR CYLINDER

1020 — TIME-UP
?
NO

1022 — YES

DRIVE
PULSE MOTORS — 1034

1036 — INITIAL
POSITION
? — NO

1038 — YES

ACTUATE
AIR CYLINDER

1040 — MOVABLE
FRAME UPSHIFTED
? — NO

1042 — YES

RELEASE
PALLET

END

FIG. 7

FIG.8

FIG.9

FIG. 10

STEP 1016

*1102*

RE-ADJUSTMENT ? — NO

YES

READ ANGULAR POSITION DATA — *1106*

DERIVE ADJUSTING MAGNITUDE — *1108*

DRIVE PULSE MOTOR — *1110*

CLEAR ANGULAR POSITION DATA — *1104*

RETURN

*FIG. 11*

STEP 1014

*1202*

IS RESPONSING ABILITY HIGH ? — NO

YES

DRIVE PULSE MOTOR — *1206*

DRIVE PULSE MOTOR — *1204*

IS OUTPUT CHANGED ? — *1208*

STOP PULSE MOTOR — *1210*

RETURN

*FIG. 12*